Europäisches Patentamt

(19) European Patent Office

Office européen des brevets

(11) Publication number: **0 150 578**
**B1**

(12) **EUROPEAN PATENT SPECIFICATION**

(45) Date of publication of patent specification: **06.04.88**

(51) Int. Cl.⁴: **C 03 B 37/018**

(21) Application number: **84307956.7**

(22) Date of filing: **16.11.84**

(54) Manufacture of optical fibre preforms.

(30) Priority: **21.12.83 GB 8334014**

(43) Date of publication of application:
**07.08.85 Bulletin 85/32**

(45) Publication of the grant of the patent:
**06.04.88 Bulletin 88/14**

(84) Designated Contracting States:
**DE FR IT**

(56) References cited:
**GB-A-1 415 141**
**GB-A-2 068 359**
**GB-A-2 093 829**

(73) Proprietor: **The General Electric Company, p.l.c.**
**1 Stanhope Gate**
**London W1A 1EH (GB)**

(72) Inventor: **Nichols, Bruce Armstrong**
**20 East Court**
**Wembly Middlesex (GB)**
Inventor: **Evans, Ronald Albert**
**76 Forest Drive West**
**Leytonstone London, E11 (GB)**
Inventor: **Greenham, Adrian Clement**
**19 Bulmer Gardens Kenton**
**Harrow Middlesex (GB)**
Inventor: **Cundy, Steven Langford**
**7 Golf Close**
**Stanmore Middlesex (GB)**

(74) Representative: **Kirby, Harold Victor Albert**
**Central Patent Department Wembley Office The**
**General Electric Company, p.l.c. Hirst Research**
**Centre East Lane**
**Wembley Middlesex HA9 7PP (GB)**

Courier Press, Leamington Spa, England.

## Description

This invention relates to the manufacture of glass optical fibre preforms according to the precharacterizing part of claim 1. From the manufactured preforms optical fibre waveguides can be produced by drawing. In this known method a chemical reaction is caused to take place between oxygen and the vapour or vapours of one or more compounds such as halides, which reaction results in the formation of a coating composed essentially of one or more oxides on a glass substrate surface. The substrate surface on which the coating is formed may be the interior surface of a glass tube or the exterior surface of a glass core.

This method, and forms of apparatus used for carrying out this method are disclosed in Patents Nos. GB 2079267 and GB 2093829, to which reference should be made for further details.

Methods which have been proposed for promoting a said chemical reaction include the application of heat, and the production of a plasma in the gaseous mixture. It will be seen from the above mentioned patents and applications that one form of a plasma-exciting device is a microwave cavity located around one end of the substrate tube, abutting an electrically conductive tube positioned coaxially around the glass tube system, and supplied with sufficient power to produce a plasma column of the required length, for example by means of a microwave generator.

In a different embodiment an electrically conductive tube is positioned coaxially around the glass tube system where the chemical reaction is to take place, and actually forms part of the microwave cavity extending along the tube system for a distance corresponding to the desired length of plasma column. The arrangements are such that the combination of the conductive tube and the plasma column produced in operation constitute a coaxial waveguide by which power from the generator is coupled to the plasma, and a progressive electromagnetic wave is launched along the waveguide, promoting increased extension of the plasma column for a given power input to the cavity.

Hitherto the conductive tube has been constituted either by the inner wall of a tubular furnace employed for external heating of the system or by a separate metal tube, made of, for example, Inconel (Registered Trade Mark).

However, it has been found that metal ions from this metal tube tend to diffuse through to the substrate and/or coating and contaminate the preform, which can have the effect of impairing the performance of optical fibre formed from it.

It is thus an object of the present invention to provide a method manufacturing optical fibre preforms in which contamination from metal ions has been removed or at least significantly reduced.

Accordingly, the invention provides a method of the type specified in which the gases flowing into the space between a perforated and supply tube and substrate are caused to react by the production of a plasma in the gaseous mixture by means of a microwave cavity powered by a microwave generator and having a conductive tube positioned coaxially around said substrate so as to form a waveguide wherein said conductive tube is made of conductive carbon.

Preferably the tube is made of graphite.

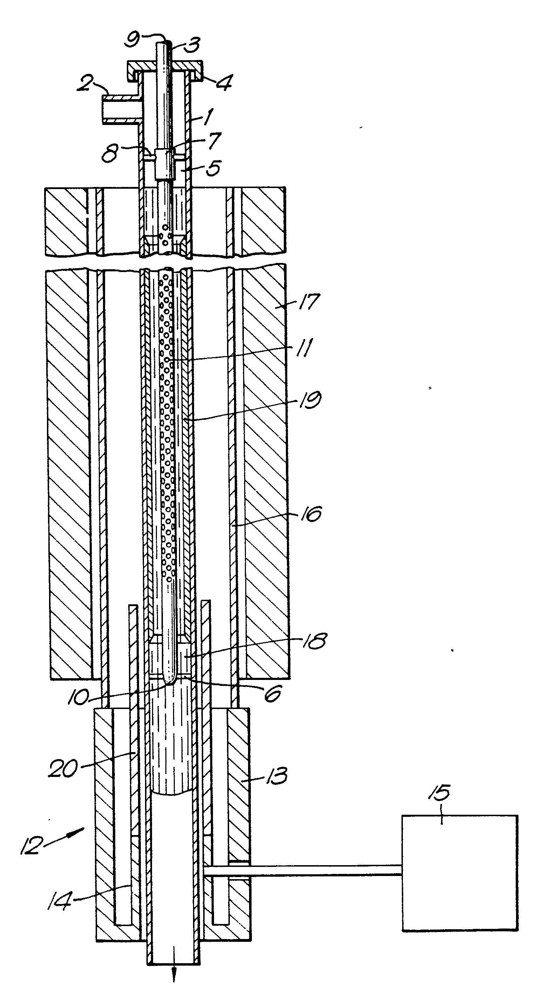

One method in accordance with the invention will now be described by way of example with reference to the drawing which shows, in part-sectional elevation, apparatus employed for carrying out the method.

In the drawing, a vitreous silica substrate tube 1, supported vertically, has an inlet for gas which may be a side tube 2 adjacent to its upper end, or alternatively (not shown) a tube inserted through a seal at its upper end, and an inner tube 3 of vitreous silica is sealed through a cap 4 closing the upper end of the tube 1, forming an annular space 5 between the tubes 1 and 3. The tube 3 is located coaxially within the substrate tube by means of three silica projections 6 attached to its lower end and abutting against the substrate tube wall, and a short length of closely fitting silica tube 7 with similar projections 8 which is placed over the tube 3 near its upper end. The open upper end 9 of the tube 3 is connected to means (not shown) for supplying the required mixture of carrier gas and reactant vapour or vapours to this tube, the lower end 10 of the tube 3 is closed, and the wall of the tube 3 is pierced by a multiplicity of perforations 11 (shown greatly enlarged) to permit egress of the reactant vapours and carrier gas into the space 5 which constitutes the reaction zone. The lower end of the substrate tube 1 is connected to a vacuum pump (not shown), for exhaustion of the tube as indicated by the arrow.

A microwave cavity 12, formed of an outer cylinder 13 and an inner cylinder 14 of predetermined height, is located adjacent to the gas exit end of the tube 1, the lower end of the tube being inserted through the inner cylinder 14. Power is supplied to the cavity from a microwave generator 15. A waveguide tube 16 of circular cross-section, formed of graphite, is also positioned around the substrate tube, extending from the top of the microwave cavity nearly to the gas inlet tube 2, and the tube 16 is surrounded by a tubular electric furnace 17. When the gaseous mixture is passed into the annular space (for further details of the composition of the mixture see the second above mentioned patent) and power is supplied to the microwave cavity, a plasma column 18 is established in space 5 causing continuous deposition of a glass coating 19 on the substrate tube 1.

It has been found that by making the conductive tube 18 of carbon such as graphite, the problem of contamination of the preform due to diffusion of metal ions from a metal conductive tube disappears. For this reason, the upper part 20 of the cylinder 14 is also made of carbon such as graphite and is made to reach a point near to the lowest set of perforations 11 in the tube 3, so that as little of the plasma column 18 as possible is "wasted".

Clearly, this method of manufacturing preforms may be employed in any system which uses microwave power to excite a plasma for promoting a chemical reaction used to deposit glass on a substrate. For example, the method could be followed using apparatus including two microwave cavities and generators, one at each end of the substrate tube.

It will also be understood that the term "glass preform" includes within its scope glass tubes which may be used in the production of optical fibre waveguides, but which need to undergo further treatment or processing or to be combined with other glass structures before being drawn to form such waveguides.

**Claims**

1. A method of manufacturing a glass optical fibre preform in which a coating composed essentially of one or more oxides is formed on a surface of an elongate cylindrical glass substrate (1) by causing a chemical reaction to take place between oxygen and the vapour or vapours of one or more compounds capable of reacting with oxygen to produce the desired coating material, wherein a tube (3) which has a multiplicity of perforations (11) through its wall is supported coaxially with the substrate (1), an annular space (5) being provided between said tube (3) and the substrate (1), and a gaseous mixture consisting of oxygen and said vapour or vapours, and optionally an additional carrier gas, is caused to flow into the said annular space (5) by being passed through the perforations (11) in said tube (3), a sufficient gas pressure differential being maintained between the interior and exterior of said tube (3) to cause gas to flow through the perforations (11) into said annular space (5), while at least a major part of the length of the substrate (1) is maintained at an elevated temperature, and a chemical reaction is caused to take place throughout the annular space (5) by production of a plasma in said space (5), said plasma being generated by means of a microwave cavity (12) powered by a microwave generator (15) and a conductive tube (16) which is positioned coaxially around the glass substrate (1), said conductive tube (16) abutting the microwave cavity (12) so as to form a wave guide, whereby a coating (19) of one or more oxides resulting from the said reaction is formed simultaneously on the whole of said surface of the heated length of the substrate (1) while residual gases and gaseous reaction products are withdrawn from said annular space (5) characterised in that said tube (16) is made of conductive carbon.

2. A method according to Claim 1 characterised in that said tube (16) is made of graphite.

**Patentansprüche**

1. Verfahren zur Herstellung einer Vorform optischer Glasfasern, in welchem ein Überzug, der im wesentlichen aus einem oder mehrerer Oxide zusammengesetzt ist, auf einer Oberfläche eines länglichen zylindrischen Glassubstrats (1) ausgebildet wird, indem das Stattfinden einer chemischen Reaktion zwischen Sauerstoff und dem Dampf oder den Dämpfen einer oder mehrerer Verbindungen verursacht wird, die imstande sind, mit Sauerstoff zu reagieren, um das gewünschte Überzugsmaterial zu erzeugen, in welchem eine eine Vielzahl von Perforationen (11) durch ihre Wandung aufweisende Röhre (3) koaxial mit dem Substrat (1) gehaltert ist, ein ringförmiger Raum (5) zwischen der Röhre (3) und dem Substrat (1) ausgebildet ist und eine aus Sauerstoff und diesem Dampf oder diesen Dämpfen und gedarfsweise einem zusätzlichen Trägergas bestehende gasförmige Mischung veranlaßt wird, in den ringförmigen Raum (5) zu strömen, indem sie durch die Perforationen (11) in der Röhre (3) geleitet wird, wobei ein ausreichendes Gasdruckdifferential zwischen dem Inneren und Äußeren der Röhre (3) aufrechterhalten wird, um das Gas zu veranlassen, durch die Perforationen (11) in den ringförmigen Raum (5) zu strömen, während zumindest ein Hauptteil der Länge des Substrats (1) auf einer erhöhten Temperatur gehalten wird und das Stattfinden einer chemischen Reaktion überall im ringförmigen Raum (5) durch Erzeugen eines Plasmas in diesem Raum (5) hervorgerufen wird, wobei das Plasma mittels eines durch einen Mikrowellengenerator (15) gespeisten Mikrowellenhohlraum (12) und einer leitfähigen Röhre (16), die um das Glassubstrat (1) herum koaxial angeordnet ist, erzeugt wird, welche leitfähige Röhre (16) derart an den Mikrowellenhohlraum (12) stößt, daß ein Wellenleiter ausgebildet wird, wodurch ein Überzug (19) eines oder mehrerer Oxide, die aus dieser Reaktion resultieren, simultan auf der gesamten Oberfläche der erwärmten Länge des Substrats (1) ausgebildet wird, während Restgase und gasartige Reaktionsprodukte vom ringförmigen Raum (5) abgezogen werden, dadurch gekennzeichnet, daß die Röhre (16) aus leitendem Kohlenstoff hergestellt ist.

2. Verfahren nach Anspruch 1, dadurch gekennzeichnet, daß die Röhre (16) aus Graphit hergestellt ist.

**Revendications**

1. Procédé de fabrication d'une ébauche de fibre optique de verre, dans lequel un revêtement composé essentiellement d'un ou plusieurs oxydes est formé sur une surface d'un substrat cylindrique allongé (1) de verre, par réaction chimique entre de l'oxygène et la vapeur ou les vapeurs d'un ou plusieurs composés capables de réagir avec l'oxygène avec formation de la matière voulue de revêtement, dans lequel un tube (3) ayant de multiples perforations (11) traversant sa paroi est supporté coaxialement au substrat (1), un espace annulaire (5) étant formé entre le tube (3) et le substrat (1), et un mélange gazeux constitué d'oxygène et de la vapeur ou des vapeurs et éventuellement un véhicule gazeux supplémentaire, est mis en circulation dans l'espace annulaire (5) par passage dans les perforations (11) du tube (3), une pression différentielle suffisante étant maintenue dans le gaz entre l'intérieur et l'extérieur du tube (3) pour que le gaz s'écoule dans les perforations (11) et pénètre dans l'espace annulaire (5), alors que la plus grande partie au moins de la longueur du substrat (1) est maintenue à une température élevée, et une réaction chimique est provoquée dans l'espace annulaire (5) par production d'un plasma dans cet espace (5), le plasma étant créé à l'aide d'une cavité (12) en hyperfréquences alimentée par un générateur (15) d'hyperfréquences et un tube conducteur (16) qui est placé coaxialement autour du substrat de verre (1), le tube conducteur (16) étant en butée contre la cavité (12) en hyperfréquences afin qu'un guide d'onde soit formé, si bien qu'un revêtement (19) d'un ou plusieurs oxydes résultant de la réaction est formé simultanément sur toute la surface de la longueur chauffée du substrat (1), les gaz résiduels et les produits gazeux, de la réaction étant retirés de l'espace annulaire (5), caractérisé en ce que le tube (16) est formé de carbone conducteur.

2. Procédé selon la revendication 1, caractérisé en ce que le tube (16) est formé de graphite.